# DEMANDE DE BREVET EUROPEEN

(11) **EP 2 237 005 A1**
(43) Date de publication de la demande: **06.10.2010**
(21) Numéro de dépôt: 10157692.4
(22) Date de dépôt: 25.03.2010
(51) Int. Cl.: G01J 5/02, G01J 5/22, H01L 21/02, H01L 31/02, H01L 23/522

(54) **Pixel de bolometre dote d'un condensateur d'integration mim**

(30) Priorité: 31.03.2009 FR 0952033
(71) Demandeur: Commissariat à l'Énergie Atomique et aux Énergies Alternatives, 75015 Paris (FR)
(72) Inventeur: DUPONT, Bertrand, 84400, GARGAS (FR)
(74) Mandataire: Ilgart, Jean-Christophe

(57) **Abrégé**

Dispositif microélectronique imageur thermique comprenant :
- un support (200),
- une pluralité de niveaux (M1,..., M5, M6) métalliques d'interconnexions de composants électroniques formés sur le support,
- une matrice de détecteurs thermiques formée sur le support, chaque détecteur comportant une membrane (210) permettant d'absorber une énergie rayonnante et de fournir un ou plusieurs signaux électriques en fonction de l'énergie rayonnante absorbée, et des moyens de lecture des signaux électriques issus de la membrane, les moyens de lecture étant intégrés au support,

au moins plusieurs des dits détecteurs ayant des moyens de lecture dotés d'un intégrateur comprenant au moins un condensateur d'intégration MIM formé en regard de la membrane, le condensateur MIM ayant au moins une armature (244) supérieure réalisée dans un niveau métallique donné d'interconnexion de ladite pluralité de niveaux (M1,..., M5, M6) métalliques d'interconnexions.

## Description

### DOMAINE TECHNIQUE

L'invention concerne le domaine des dispositifs de détection de rayonnements électromagnétiques, en particulier ceux basés sur le principe de la détection thermique tels que les bolomètres.

Elle prévoit un capteur d'image thermique, utilisé par exemple dans le domaine de l'imagerie infrarouge, et formé d'une matrice de cellules ou pixels comportant un capteur à bolomètre associé à un circuit de lecture ayant un agencement amélioré.

Elle apporte des améliorations en termes de densité d'intégration et de qualité du signal en sortie du circuit de lecture.

### ART ANTÉRIEUR

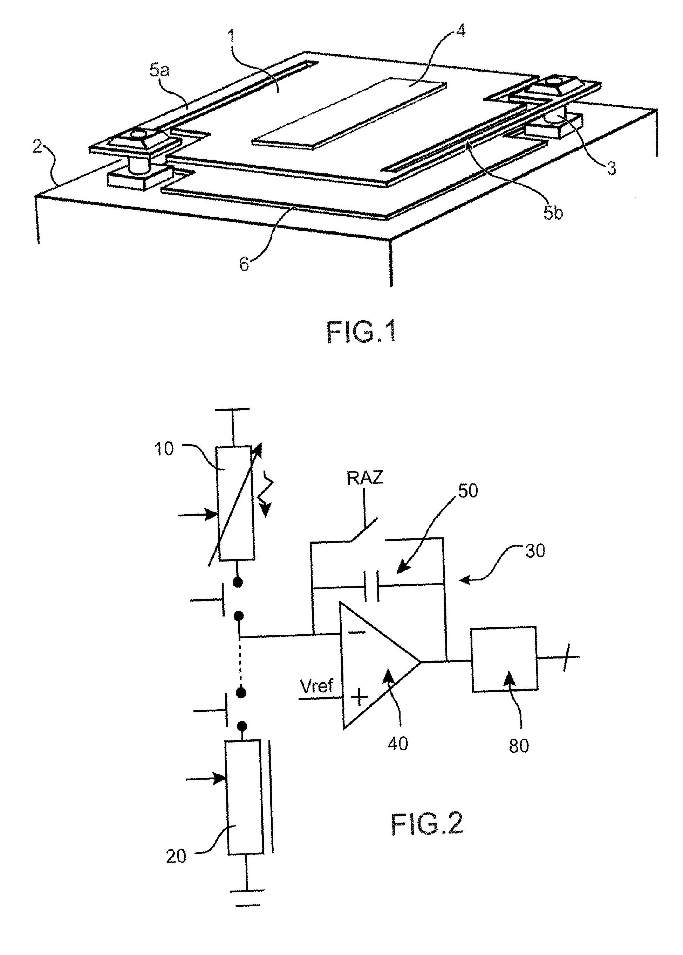

Un exemple d'agencement de capteur à bolomètre est donné sur la figure 1.

Ce dispositif comprend tout d'abord une membrane 1 absorbante vis-à-vis de rayonnements électromagnétiques incidents. Cette membrane 1 est suspendue au-dessus d'un support 2 par l'intermédiaire de plots conducteurs 3 de l'électricité.

Sous l'effet d'un rayonnement électromagnétique, la membrane 1 est susceptible de s'échauffer et de transmettre sa température à une couche 4, qui peut être semi-conductrice et comprendre par exemple un ou plusieurs thermistors permettant de transformer une énergie rayonnante en un signal électrique de mesure.

Le support 2 peut être une couche supérieure d'un dispositif microélectronique comprenant un ou plusieurs circuits intégrés, et en particulier au moins un circuit de lecture des mesures effectuées.

Le détecteur peut comprendre en outre des bras 5a, 5b dotés chacun d'une extrémité rattachée à la membrane 1 et d'une autre extrémité rattachée aux plots d'ancrage 3 et par laquelle la membrane 1 est maintenue en suspension au dessus du support 2. Sur une majeure partie de leur longueur, les bras 5a, 5b sont, espacés de la membrane 1, de manière à limiter les pertes thermiques de la membrane et d'améliorer ainsi la sensibilité du détecteur.

Une couche 6 réfléchissant les rayonnements électromagnétiques peut être placée sur le support 2, en regard de la membrane 1. La distance entre cette couche 6 et la membrane 1 est dictée par la hauteur des plots d'ancrage 3. Cette distance peut être égale au quart de la longueur d'onde détectée afin de créer une cavité quart d'onde permettant d'augmenter l'absorption de la membrane.

Un capteur d'image thermique est généralement formé d'une matrice de X x Y pixels ou cellules élémentaires dotées chacune d'un détecteur tel que décrit en liaison avec la figure 1.

Ainsi, en imagerie infrarouge, on utilise un imageur comprenant une matrice de pixels pour capter le flux infrarouge, avec un bolomètre par pixel afin de réaliser une image infrarouge d'une scène, c'est-à-dire d'une surface couverte lors de l'enregistrement d'une image et dont le gabarit résulte des conditions d'observation et des propriétés du capteur utilisé.

Un bolomètre fonctionne comme un capteur résistif dont la résistance varie avec la température et donc avec le flux de rayonnement provenant de la scène. Pour lire la valeur de la résistance du bolomètre qui correspond à un flux infrarouge, on peut par exemple imposer une tension et mesurer un courant.

Un schéma électrique d'une cellule de capteur à bolomètre et de son circuit de lecture associé, est donné sur la figure 2.

Dans ce dispositif, on soustrait au courant issu d'un détecteur 10, un courant de valeur fixe prédéterminée, par exemple de valeur proche de la valeur moyenne du courant du capteur.

Ce courant de valeur fixe est issu d'une source de courant fixe, qui peut être formée par exemple à l'aide d'un bolomètre de référence 20 insensible ou rendu insensible au rayonnement observé. Les bolomètres de référence peuvent être prévus par exemple en pied de colonne ou en tête de ligne d'une matrice de pixels.

On cherche ainsi à obtenir un courant à intégrer aussi petit que possible et qui correspond aux variations de la résistance du bolomètre sensible sous l'effet du flux de rayonnement électromagnétique de la scène.

Le courant issu de la différence entre le courant provenant du bolomètre sensible et du courant provenant du bolomètre de référence est converti en tension grâce à un intégrateur 30, qui peut être formé d'un comparateur 40 et d'un condensateur d'intégration 50 de capacité Cint situé entre une entrée inverseuse et la sortie du comparateur 40.

Des moyens d'échantillonnage 80 peuvent être prévus en sortie de l'intégrateur 30.

L'intégration d'un bolomètre de référence au sein d'un pixel sensible pose des problèmes d'encombrement, de consommation et de précision de détection.

Dans les capteurs matriciels d'images à bolomètres, les capacités d'intégration ainsi que le comparateur 40 sont généralement situées en pied de colonne.

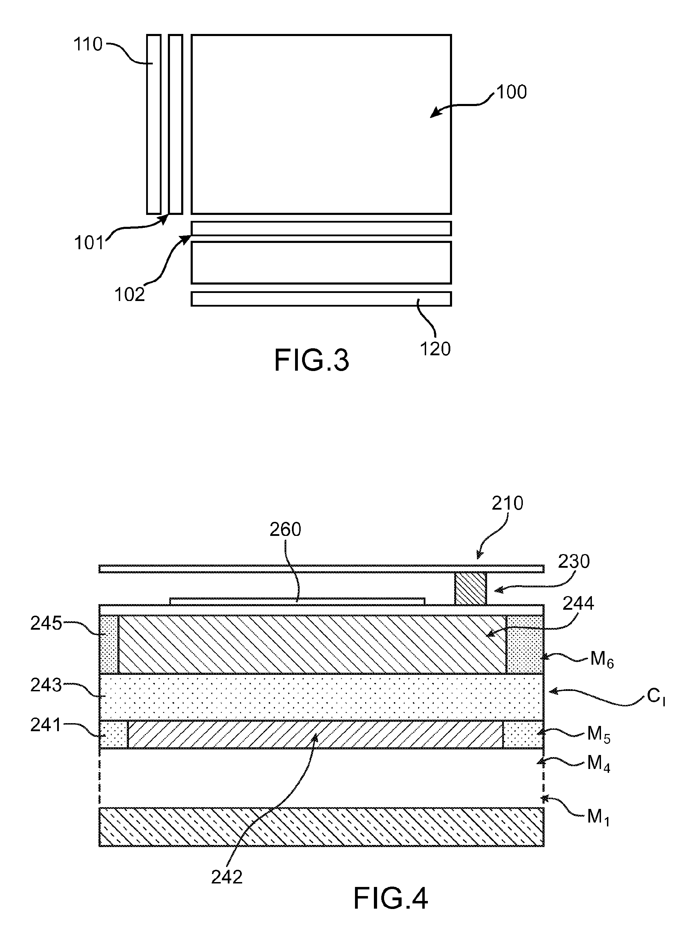

Sur la figure 3, un exemple d'agencement d'un dispositif imageur thermique suivant l'art antérieur, est donné.

Le dispositif comprend une matrice 100 de capteurs à bolomètre sensibles, un premier ensemble 101, et un deuxième ensemble 102 de capteurs de référence rendus insensibles au rayonnement observé, agencées le long de la matrice, ainsi qu'un circuit d'adressage 110 des lignes de la matrice 100, et un circuit d'adressage 120 des colonnes de la matrice. Les capacités d'intégration des circuits de lecture, sont généralement disposées à l'extérieur de la matrice de capteurs sensibles, en pied de colonne, par exemple entre l'ensemble 102 de capteurs de référence, et le circuit d'adressage colonne 120.

Certains capteurs dédiés aux imageur IR non refroidis sont peu résistifs et ont une réponse à la scène très faible. Il est donc nécessaire de les polariser fortement pour avoir un rapport signal sur bruit satisfaisant.

Avec certaines technologies et lorsque l'on doit intégrer des courants importants, on arrive à une situation où la surface requise pour intégrer les capacités en pied de colonne pourrait devenir supérieure à la zone sensible de la matrice.

Le document US 5 021 663 divulgue un dispositif microélectronique imageur thermique comprenant : une pluralité de niveaux métalliques d'interconnexions de composants électroniques formés sur un support, ainsi qu'une matrice de détecteurs thermiques formée sur le support, chaque détecteur comportant une membrane permettant d'absorber une énergie rayonnante et de fournir un ou plusieurs signaux électriques en fonction de l'énergie rayonnante absorbée, et des moyens de lecture des signaux électriques issus de la membrane.

Il se pose le problème de trouver un nouveau dispositif de détection, qui présente des améliorations notamment en termes d'encombrement

### EXPOSÉ DE L'INVENTION

L'invention concerne tout d'abord un dispositif microélectronique imageur à détection thermique comprenant :
- un support,
- une pluralité de niveaux métalliques d'interconnexions de composants électroniques formés sur le support,
- une matrice de détecteurs thermiques formée sur le support, chaque détecteur comportant une membrane permettant d'absorber une énergie rayonnante et de fournir un ou plusieurs signaux électriques en fonction de l'énergie rayonnante absorbée, et des moyens de lecture des signaux électriques issus de la membrane, les moyens de lecture étant intégrés au support,
au moins plusieurs des dits détecteurs ayant des moyens de lecture dotés d'un intégrateur comprenant au moins un condensateur d'intégration formé en regard de la membrane, le condensateur ayant au moins une armature supérieure réalisée dans un niveau métallique donné d'interconnexion de ladite pluralité de niveaux métalliques d'interconnexions.

Du fait de la disposition du condensateur d'intégration en regard de la membrane, le dispositif a un encombrement réduit.

Par rapport à un dispositif dans lequel les condensateurs d'intégration sont situés en pied de colonne, un gain de place important peut être obtenu.

Le condensateur MIM peut avoir son armature inférieure réalisée dans un autre des dits niveaux métalliques d'interconnexion.

L'armature supérieure peut être connectée à un ou plusieurs via ou éléments conducteurs d'interconnexion verticaux permettant d'établir une connexion avec un circuit de lecture.

Une des armatures peut être partagée par des détecteurs d'une même rangée de détecteurs de la matrice.

Lorsqu'au moins une des armatures du condensateur d'intégration parcourt toute une colonne de la matrice, on peut utiliser cette armature pour faire circuler l'information en courant provenant d'un détecteur.

L'armature supérieure peut être partagée par les détecteurs d'une même rangée de détecteurs de la matrice.

Afin d'éviter tout couplage qui pourrait dégrader le signal, on peut ainsi faire transiter le signal sur l'armature la plus éloignée du substrat sur lequel les différents niveaux métalliques d'interconnexion ont été réalisés.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un exemple d'un détecteur thermique à bolomètre suivant l'art antérieur,
- la figure 2, illustre un exemple d'agencement, suivant l'art antérieur, d'un capteur à bolomètre et de son circuit de lecture associé,
- la figure 3, illustre un agencement selon l'art antérieur, d'un dispositif microélectronique comprenant une matrice de capteurs à bolomètres, et en particulier des capacités d'intégration des circuits de lectures associés suivant l'art antérieur,
- la figure 4, illustre un exemple de dispositif microélectronique comprenant une matrice de capteurs à bolomètres suivant l'invention, dans lequel chaque capteur à bolomètre comprend un condensateur d'intégration MIM formé en regard d'un détecteur à bolomètre,
- la figure 5, illustre un autre exemple de dispositif microélectronique comprenant une matrice de capteurs à bolomètres suivant l'invention, dans lequel chaque capteur à bolomètre comprend un condensateur d'intégration MIM formé en regard d'un détecteur à bolomètre,
- la figure 6, illustre un exemple de dispositif microélectronique comprenant une matrice de cellules dotés de capteurs à bolomètres, dans lequel chaque cellule comprend un condensateur d'intégration MIM formé en regard d'un détecteur à bolomètre.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de dispositif microélectronique suivant l'invention, doté d'un capteur à bolomètre est donné sur la figure 4.

Ce dispositif comprend un substrat 201, par exemple un substrat semi-conducteur ou semi-conducteur sur isolant tel qu'un substrat SOI (SOI pour « silicon on insulator »), sur lequel une pluralité de composants électroniques, et de niveaux métalliques d'interconnexions superposés sont formés.

Le dispositif peut comporter k (avec k un entier non nul) niveaux métalliques d'interconnexions superposés, chaque niveau comprenant une ou plusieurs lignes conductrices horizontales, parallèles au substrat 201 et un ou plusieurs éléments d'interconnexion verticaux, communément appelés « vias » permettant de relier des lignes conductrices de niveaux différents entre elles.

Sur l'exemple de la figure 4, le dispositif comporte k = 6 niveaux métalliques d'interconnexions M1, M2, M3, M4, M5, M6 (les composants et les 3 premiers niveaux métalliques d'interconnexion M1, ..., M4, étant représentés de manière schématique par un bloc en traits discontinus au-dessus du substrat 201).

La partie sensible du capteur à bolomètre peut avoir un agencement tel que décrit précédemment en liaison avec la figure 1 et être dotée d'une membrane 210 placée au dessus d'un empilement de couches reposant sur le support 201. La membrane 210 est suspendue au-dessus du support 200 qui est formé d'un empilement de couches reposant sur le substrat 201, et dans lequel la pluralité de niveaux d'interconnexions a notamment été réalisée.

Des plots conducteurs 230, servent à la fois à maintenir la membrane au dessus du substrat et à véhiculer des signaux électriques issus de la membrane et qui sont représentatifs d'une énergie thermique détectée.

Une couche réfléchissante 260 de rayonnements électromagnétiques peut être prévue sur l'empilement, en regard de la membrane 210. La distance entre cette couche 260 et la membrane 210 est dictée par la hauteur des plots conducteurs 230, et peut être prévue en fonction de la longueur d'onde du rayonnement détecté.

Le condensateur C_{I} est un condensateur MIM pour (MIM pour « Métal Isolant Métal ») dont l'armature supérieure 244 est formée dans un niveau métallique d'interconnexion donné, par exemple dans le dernier niveau métallique M6 d'interconnexion, c'est-à-dire le niveau le plus éloigné du substrat 201.

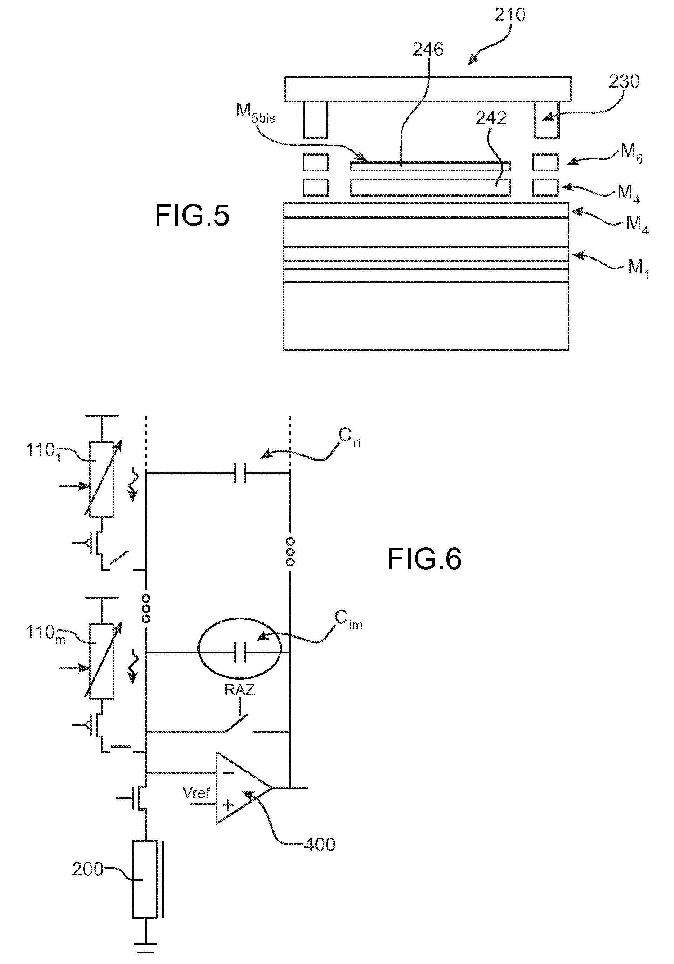

Selon une variante (figure 5), le condensateur C_{I} est doté d'une armature supérieure 246 formée dans un niveau métallique d'interconnexion M5bis, c'est-à-dire une couche métallique qui est située entre le niveau métallique M5 et le dernier niveau métallique M6 le niveau le plus éloigné du substrat 201, le niveau métallique d'interconnexion M5bis étant relié au dernier niveau M6.

L'armature inférieure 242 peut être formée dans un autre niveau métallique d'interconnexion, par exemple dans l'avant dernier niveau métallique M5 d'interconnexion.

L'armature supérieure 244 et l'armature inférieure 242 peuvent être sous forme de zones métallique réalisées respectivement dans des couches isolantes 245 et 241.

Les armatures supérieure 244 et inférieure 242 peuvent être formées par exemple à base de Cuivre ou d'aluminium et séparées entre elles par une couche isolante 243, qui peut être par exemple à base de SiO₂.

L'armature supérieure 244 du condensateur d'intégration C_{I} peut être connectée à un comparateur (non représenté) par exemple à l'entrée inverseuse du comparateur, tandis que l'armature inférieure 244 est connectée à la sortie du comparateur.

Sur les figures 4 et 5, seule une cellule ou un pixel d'un dispositif microélectronique détecteur thermique, est représenté. Un tel dispositif comprend une pluralité de capteurs à bolomètre agencés selon une matrice et des moyens ou des circuits de lecture associés également arrangés selon une matrice en regard de la matrice des capteurs à bolomètre.

Selon une possibilité de mise en oeuvre (non représentée), le condensateur d'intégration C_{I} peut être formé de plusieurs condensateurs montés en parallèle, par exemple de 3 capacités montés en parallèle.

Dans ce cas, les condensateurs mis en parallèle peuvent être dotés chacun d'une armature supérieure formée dans le dernier niveau métallique M6, qui peut être connectée à au moins une autre armature supérieure d'un autre condensateur formé dans le dernier niveau métallique M6, et chacun d'une armature inférieure qui peut être formée dans l'avant dernier niveau métallique M5, et qui peut être connectée à au moins une autre armature inférieure d'un autre condensateur formé dans l'avant dernier niveau métallique M5.

Selon une possibilité de mise en oeuvre, l'armature supérieure 244, du condensateur d'intégration peut appartenir à une piste métallique qui peut être partagée par plusieurs cellules et éventuellement par toutes les cellules d'une même colonne de la matrice.

L'armature inférieure 242 du condensateur d'intégration C_{I} peut également appartenir à une autre piste métallique qui peut être partagée par plusieurs cellules et éventuellement par toutes les cellules d'une même colonne de la matrice.

Dans le cas où l'armature métallique supérieure 244 du condensateur d'intégration appartient à une piste métallique partagée par les cellules d'une même colonne de la matrice, cette armature peut en outre servir à acheminer le signal issu d'un capteur à bolomètre et faire office de bus de colonne. En acheminant le signal par l'armature la plus éloignée du substrat 201 et des composants formés sur ce dernier, on limite les phénomènes de couplage.

Un tel agencement est donné par exemple sur la figure 6, sur laquelle des détecteurs à bolomètre 110₁, ..., 110ₘ appartenant à des cellules d'une même colonne d'un dispositif matriciel, sont représentés.

Un bolomètre de référence 200 est prévu par exemple en pied de colonne, tandis que le courant issu de la différence entre le courant provenant d'un bolomètre sensible et du courant provenant du bolomètre de référence est converti en tension grâce à un intégrateur, formé d'un comparateur 400 et de condensateurs d'intégration CI1, ...CIm mis en parallèles et dont les armatures font office de bus de colonne.

## Revendications

1. Dispositif microélectronique imageur thermique comprenant :
- un support (200),
- une pluralité de niveaux (M1, ..., M5, M6) métalliques d'interconnexions de composants électroniques formés sur le support,
- une matrice de détecteurs thermiques formée sur le support, chaque détecteur comportant une membrane (210) permettant d'absorber une énergie rayonnante et de fournir un ou plusieurs signaux électriques en fonction de l'énergie rayonnante absorbée, et des moyens de lecture des signaux électriques issus de la membrane, les moyens de lecture étant intégrés au support,
au moins plusieurs des dits détecteurs ayant des moyens de lecture dotés d'un intégrateur comprenant au moins un condensateur d'intégration (C_{I}) formé en regard de la membrane, le condensateur ayant au moins une armature (244) supérieure réalisée dans un niveau métallique donné d'interconnexion de ladite pluralité de niveaux (M1, ..., M5, M6) métalliques d'interconnexions.

2. Dispositif microélectronique selon la revendication 1, le condensateur MIM ayant au moins une armature (242) inférieure réalisée dans un autre des dits niveaux métalliques d'interconnexion.

3. Dispositif microélectronique selon la revendication 1 ou 2, l'armature supérieure (242) étant connectée à un circuit de lecture par l'intermédiaire d'un ou plusieurs éléments d'interconnexions verticaux.

4. Dispositif microélectronique selon l'une des revendications 1 à 3, une des armatures étant partagée par des détecteurs d'une même rangée de détecteurs de la matrice.

5. Dispositif microélectronique selon la revendication 4, l'armature supérieure étant partagée par les détecteurs d'une même rangée de détecteurs de la matrice.
